(19) Europäisches Patentamt
European Patent Office
Office européen des brevets

(11) **EP 1 937 016 A1**

(12) **EUROPEAN PATENT APPLICATION**

(43) Date of publication:
**25.06.2008 Bulletin 2008/26**

(51) Int Cl.:
***H04Q 7/38*** (2006.01)

(21) Application number: **06301266.0**

(22) Date of filing: **19.12.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK RS**

(71) Applicant: **Alcatel Lucent**
**75008 Paris (FR)**

(72) Inventors:
• **Gruber, Markus**
**79825 Korntal-Münchingen (DE)**

• **Braun, Volker**
**70178 Stuttgart (DE)**
• **Kaminski, Stephen**
**73054 Eislingen (DE)**

(74) Representative: **Wetzel, Emmanuelle**
**Alcatel Lucent**
**Intellectual Property & Standards**
**70430  Stuttgart (DE)**

(54) **A method for signaling of resource assignments, a transmitter, a receiver, a base station, a user terminal and a communication network therefor**

(57)    The invention concerns a method for signaling of resource assignments of resource units into a number of resource areas by means of indicating k dedicated positions from n positions each identifying at least one of said resource units, whereby for each of the n positions identifying at least one of said resource units, an evaluation is performed in a recursive procedure using Pascal's triangle resulting in an indicator value indicating the resource assignments, a transmitter, a receiver, a base station, a user terminal and a communication network therefor.

Fig. 7

**Description**

The invention relates to a method for signaling of resource assignments according to the preamble of claim 1, a transmitter according to the preamble of claim 8, a receiver according to the preamble of claim 9, a user terminal according to the preamble of claim 10, a base station according to the preambles of claim 11, and a communication network according to the preamble of claim 12.

Resources like e.g. frequency bands or time intervals are segmented in resource units and classified for usage e.g. in mobile or fixed communication. Classifications of resources can be simple yes/no decisions, e.g. for frequency-selective transmission, or even more complex as in CQI reports (CQI = channel quality indicator), for instance. The classification must be signalled from a transmitter to a receiver to allow for a communication between the transmitter and the receiver. For simple yes/no decisions, one bit can be assigned to each resource unit of e.g. a frequency band in a straightforward approach, so the number of bits that are necessary to signal the selection status is equal to the number of resource units, i.e. in the case of a frequency band with 25 resource units one would need 25 bits. As soon as the classification information is more complex than just one bit, the signalling overhead increases correspondingly. The assignment of bits to resource units is called bit mapping.

As neighboring resource units often can be combined to resource areas having the same classification, it is reasonable to solely indicate transitions between consecutive resource areas in order to minimize the signaling information in these cases. For the indication of k realized transitions out of n possible transitions, a number of $n^k$ possibilities exist which can possibly be mapped to a number of bits that is smaller than the number of bits used for bit mapping as described above.

In order to further reduce the signaling traffic, a method for coding the transitions between consecutive resource areas, as e.g. the transition between a used frequency area and an unused frequency area, with even more reduced signaling overhead is needed.

The object of the invention is thus to propose a method for signaling of resource assignments with reduced signaling information using a coding algorithm as e.g. described in T.M. Cover "Enumerative Source Coding", IEEE Trans. Inform. Theory, vol. IT-19, no.1, pp. 73-77, January 1973.

This object is achieved by a method according to the teaching of claim 1, a transmitter according to the teaching of claim 8, a receiver according to the teaching of claim 9, a user terminal according to the teaching of claim 10, a base station according to the teaching of claim 11, and a communication network according to the teaching of claim 12.

The main idea of the invention is, that the number of possibilities to indicate k dedicated positions out of n positions each identifying at least one of resource units is equal to the binomial coefficient k-out-of-n, i.e. $\begin{pmatrix} n \\ k \end{pmatrix}$. The possibilities are coded by a transmitter into the lowest theoretically possible number of bits, namely $ld\begin{pmatrix} n \\ k \end{pmatrix}$ bits, using an algorithm, which takes advantage of Pascal's triangle. Correspondingly, the information can be readily decoded by the receiver with an analogous algorithm.

Further developments of the invention can be gathered from the dependent claims and the following description.

In the following the invention will be explained further making reference to the attached drawings.

Fig. 1 schematically shows the classification of 25 resource units into 4 resource areas by means of indicating the positions of separations between the resource areas.

Fig. 2 schematically shows Pascal's triangle.

Fig. 3 schematically shows a storage table for Pascal's triangle.

Fig. 4 schematically shows the mapping of $\begin{pmatrix} 6 \\ 3 \end{pmatrix}$ possibilities to separate a resource onto 5 bits.

Fig. 5 schematically shows an iterative way in Pascal's triangle for coding 3 dedicate positions of separations out of 6 possible positions.

Fig. 6 schematically shows an algorithm for coding positions of separations between the resource areas using Pascal's triangle.

Fig. 7 schematically shows in more detail the iterative way in Pascal's triangle for coding 3 dedicate positions of separations out of 6 possible positions.

Fig. 8 schematically shows an algorithm for decoding positions of separations between the resource areas using Pascal's triangle.

Fig. 9 schematically shows in detail an iterative way in Pascal's triangle for decoding 3 dedicate positions of separations out of 6 possible positions.

Fig. 10 schematically shows the necessary bits for the signalling of resource assignments over the total number of resource units for a number of k=8 separations between the resource areas.

Fig. 11 schematically shows the communication between a user terminal comprising a receiver and a base station comprising a transmitter.

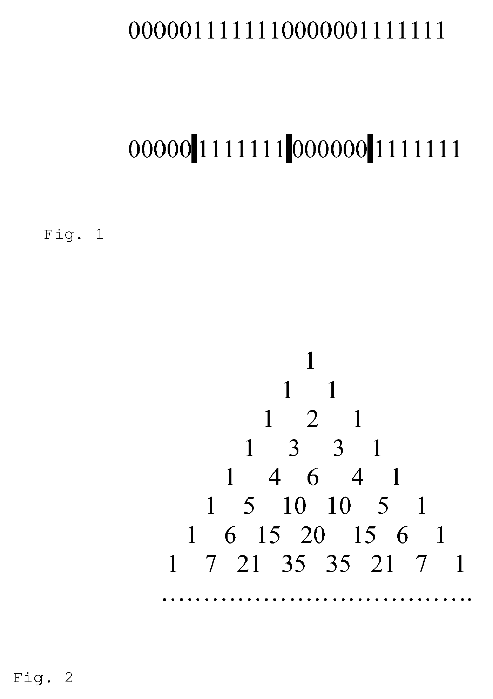

Fig. 1 shows schematically an example for a resource comprising 25 resource units, as e.g. a frequency band that is segmented into 25 frequency units. In the example, all consecutive frequency units having the same classification are combined into four resource areas. In the upper row of fig. 1, the first 5 frequency units belonging to the first frequency area are indicated by "0", the next 7 frequency units belonging to the second frequency area are indicated by "1" and the 6 frequency units of the third frequency area are again indicated by "0". That means, that adjacent frequency areas are alternatingly indicated by "0" and "1".

In this case of 2 classifications "0" and "1" for the frequency areas, it is sufficient to solely signal the positions of the separations between the resource areas, i.e. frequency areas in this case. As there are 3 separations necessary for the indication of 4 resource areas and 5 bits per separation since there are 24 possible positions of separations, one would need 3*5 bits = 15 bits for the indication of the positions of separations plus 1 bit for the classification of the first frequency area instead of 25 bits in the case of a simple yes/no classification, i.e. a bit mapping. For complex classifications this can be even more advantageous, since the classification information needs to be signaled only once per frequency area.

In the lower row in fig. 1, the positions of separations between the resource areas that have to be signaled are depicted as bars.

However, the signaling of the positions of separation as described above is still not very efficient, as it does not take into account the following:

• Once a position of separation is defined, there are less possibilities for the next position of separation, as there is no sense in choosing the same position of separation again. It is therefore possible that less signaling bits are necessary.

• Positions of separations are signalled independently of each other, although permutations do not matter. This is a waste of resources.

As a consequence, instead of using 3*5 bits = 3* ld(32) bits = 1d(32*32*32) bits = 15 bits for the indication of the positions of separations, it is sufficient to use $\mathrm{ld}\left(\binom{24}{3}\right)$ bits =

As there a $\mathrm{ld}\left(\dfrac{24*23*22}{1*2*3}\right)$ bits = 11 bits .re only $\binom{n}{k}$ possibilities to have k positions of separations in a frequency band with n+1 frequency units, we are proposing to take into account only these $\binom{n}{k}$ possibilities in order to save signaling resources, as $\binom{n}{k}$ can generally be mapped onto a smaller number of bits than

$n^k$. The main issue here is to do the mapping in a systematic way so that both the transmitter can easily convert the positions of separations into a suitable bit combination and the receiver can readily reconvert this combination into positions of separations. For this purpose, an algorithm taking advantage of Pascal's triangle is proposed.

Fig. 2 shows a Pascal's triangle, in which the binomial coefficients $\binom{n}{k}$ can be found in element k of row n when counting of rows and columns begins with zero.

Moreover, according to Pascal's rule, $\binom{n}{k} = \binom{n-1}{k-1} + \binom{n-1}{k}$ holds for all $1 \leq k \leq n$, which means that the problem to map $\binom{n}{k}$ onto a number of bits, i.e. the enumeration problem, can be broken down recursively into smaller problems.

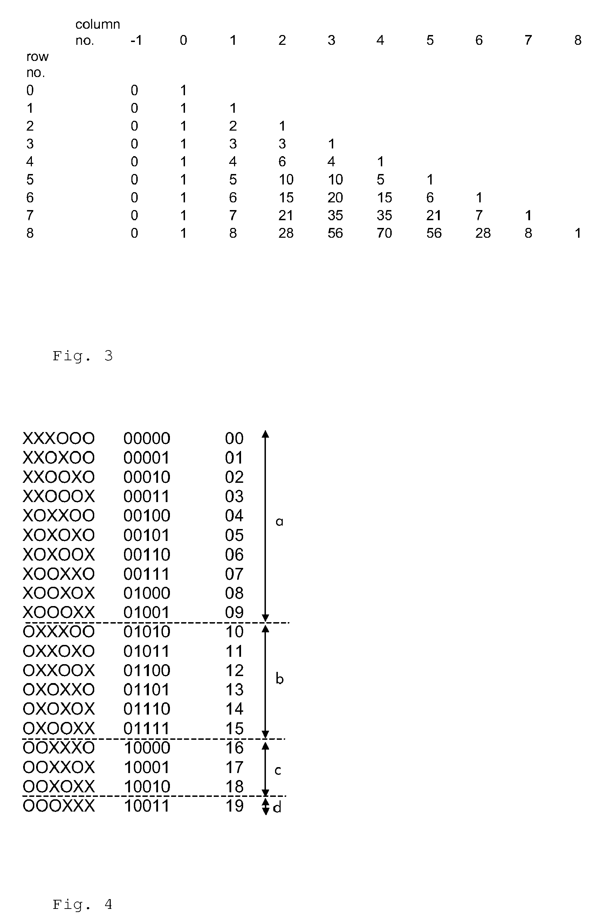

Fig. 3 shows the representation of Pascal's triangle in a storage table which allows a fast way to find the binomial coefficients $\binom{n}{k}$ as the element in the table in column k and row n.

In fig. 4 which is related to an example of mapping the binomial coefficient $\binom{6}{3} = 20$ onto 5 bits, all 20 possibilities for 3 positions of separations out of 6 possible positions are depicted each in a separate row. The rows are numbered from 0 to 19. A separation is indicated by "X" in the 6-tuple. The 6-tuples indicated with b, c, d have no separation at the first position, the 6-tuples indicated with c, d additionally have no separation at the second position and the 6-tuple indicated with d has additionally no separation at the third position.

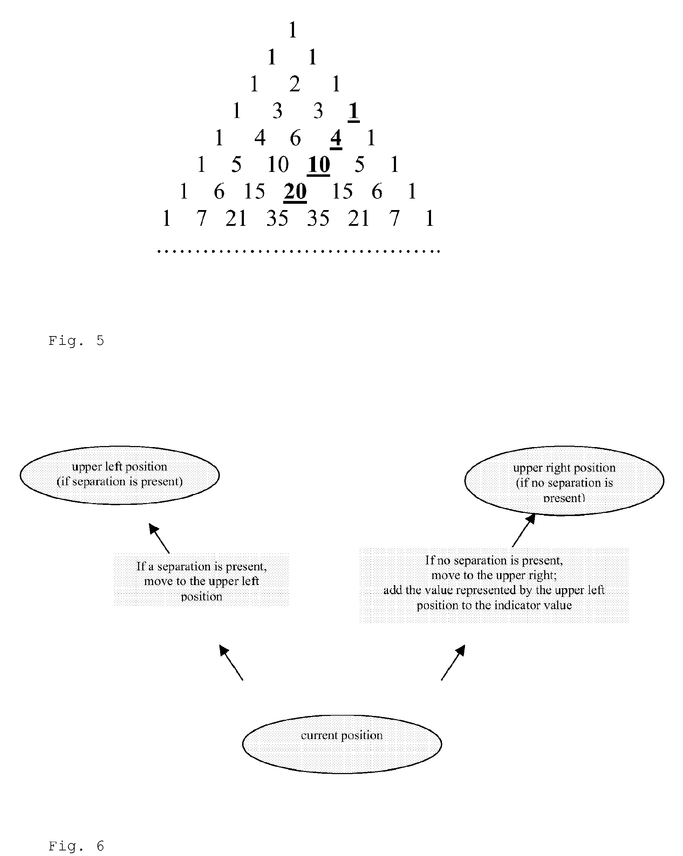

Fig. 5 shows the relevant entries in Pascal's triangle as underlined and bold that are used for mapping the binomial coefficient $\binom{6}{3} = 20$ onto 5 bits. The entry **"20"** as starting value corresponds to the binomial coefficient $\binom{6}{3} = 20$, the entry **"10"** corresponds to the 6-tuples indicated with b, c, d, the entry **"4"** corresponds to the 6-tuples indicated with c and d, and the entry **"1"** corresponds to the 6-tuple indicated with d.

In the following example also related to the case of 3 separations on 6 possible positions, the binomial coefficient $\binom{6}{3} = 20$ is to be mapped onto 5 bits. In the example, the transmitter has to signal that there is a separation at the 2nd, 3rd, and 6th position which is indicated by "X" in the 6-tuple OXXOOX.

In fig. 6, the basic principle for mapping the binomial coefficient $\binom{n}{k}$ on a number of bits is shown. From a dedicated entry in Pascal's triangle, it is decided to go to the upper left entry in Pascal's triangle, if there is a separation at the position related to the dedicated entry. If there is no separation at the position related to the dedicated entry, it is decided to go to the upper right entry in Pascal's triangle and additionally, the value represented by the upper left entry is added to a counter variable.

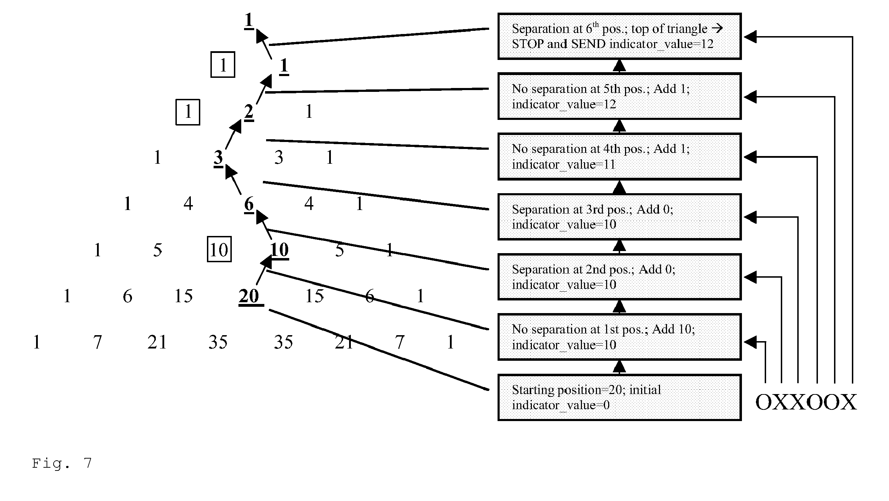

Fig. 7 shows the algorithm for mapping the binomial coefficient $\binom{6}{3} = 20$ onto 5 bits for the current example. In Pascal's triangle, the entry **"20"**, which is the starting value for the case that on 6 possible positions three separations shall be set, is differentiated into the first 10 6-tuples of positions on the upper left in Pascal's triangle representing a separation at the first position and the remaining 10 6-tuples of positions on the upper right representing no separation at the first position. As there is no separation at the first position, the first 10 6-tuples of positions can already be discarded, and the transmitter thus focuses on the upper-right entry "10" in Pascal's triangle and stores the value of the upper left entry, which is indicated by the entry "10" in a box in a counter variable, e.g. an indicator value, so that the indicator value is set to 10.

The entry "**10**" of the current position is further split into the upper-left entry "**6**" in Pascal's triangle for a separation at the $2^{nd}$ position and an upper-right entry "4" in Pascal's triangle for no separation at the second position. As there is a separation at the second position, the transmitter has to focus on the upper-left entry "**6**" and as there is a separation, nothing has to be added to the counter variable, i.e. the indicator value, so that the indicator value remains 10.

The entry "**6**" of the current position is further split into the upper-left entry "**3**" in Pascal's triangle for a separation at the third position and an upper-right entry "3" in Pascal's triangle for no separation at the third position. As there is a separation at the third position, the transmitter has to focus on the upper-left entry "**3**" and as there is a separation, nothing has to be added to the counter variable, i.e. the indicator value, so that the indicator value remains 10.

The entry "**3**" of the current position is further split into the upper-left entry "1" in Pascal's triangle for a separation at the fourth position and an upper-right entry "**2**" in Pascal's triangle for no separation at the fourth position. As there is no separation at the fourth position, the transmitter has to focus on the upper-right entry "**2**" and as there is no separation, the value of the upper left entry, which is indicated by the entry "1" in a box has to be added to the counter variable, i.e. the indicator value, so that the indicator value is set to 11.

The entry "**2**" of the current position is further split into the upper-left entry "1" in Pascal's triangle for a separation at the fifth position and an upper-right entry "**1**" in Pascal's triangle for no separation at the fifth position. As there is no separation at the fifth position, the transmitter has to focus on the upper-right entry "**1**" and as there is no separation, the value of the upper left entry, which is indicated by the entry "1" in a box has to be added to the counter variable, i.e. the indicator value, so that the indicator value is set to 12.

The entry "**1**" of the current position automatically leads to the upper-left entry "**1**" in Pascal's triangle as there is a separation at the sixth position. As there is a separation at the sixth position, nothing has to be added to the counter variable, i.e. the indicator value, so that the indicator value remains 12.

Generally, the above described iterative procedure is continued up to the last position. If for a dedicated entry, no upper left entry exists, nothing is added to the indicator value. At the end the indicator value is the value that has to be transmitted to the receiver for signaling the resource assignments.

In a preferred embodiment, if the number of positions of separations is reached before the end of the iterative procedure, the procedure stops.

The indicator value is initialised with a value between -1 and +1, but preferably with 0.

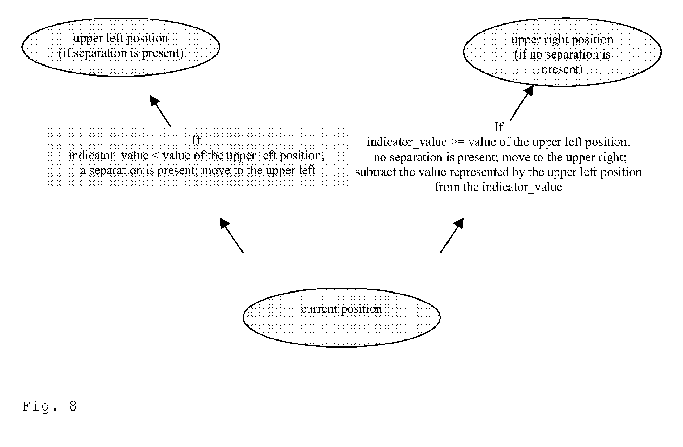

Fig. 8 shows the basic principle for decoding an indicator value using Pascal's triangle. From a dedicated entry in Pascal's triangle, it is decided to go to the upper left entry in Pascal's triangle, if the current indicator value is smaller than the value represented by the upper left entry. Furthermore a separation is present at the position related to the dedicated entry. If the current indicator value is greater than or equal to the value represented by the upper left entry, it is decided to go to the upper right entry in Pascal's triangle, and the current indicator value is decreased by the value represented by the upper left entry. Furthermore no separation is present at the position related to the dedicated entry.

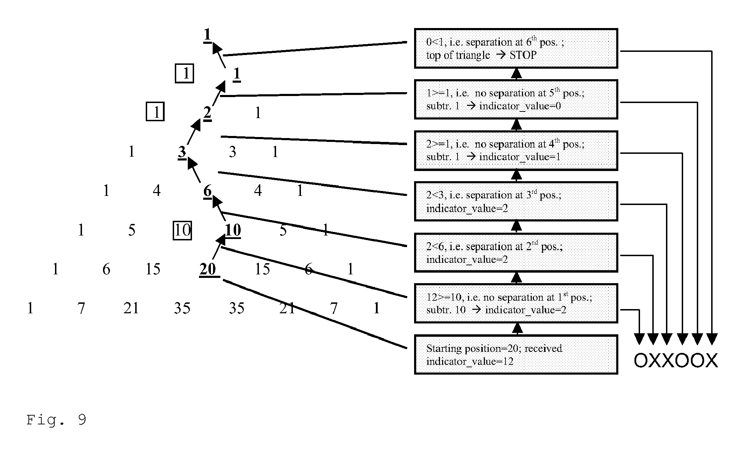

Fig. 9 shows the algorithm for decoding the indicator value of the current example in a receiver. In Pascal's triangle, the entry "**20**", representing the binomial coefficient $\begin{pmatrix} 6 \\ 3 \end{pmatrix}$ is the starting value for the case that within 6 possible positions three separations are set, and the current indicator value that has been signalled by the transmitter in the current example is 12. As 12 is greater than the upper left entry "10", the receiver focuses on the upper right entry "**10**", and no separation is present at the first position. The current indicator value is decreased by the value of the upper left entry, which is indicated by the entry "10" in a box, so that the current indicator value is set to 2.

For the entry "**10**" of the current position, the current indicator value 2 is smaller than the upper left entry "**6**", thus the receiver focuses on the upper left entry "**6**", and a separation is present at the second position. The current indicator value remains 2.

For the entry "**6**" of the current position, the current indicator value 2 is smaller than the upper left entry "**3**", thus the receiver focuses on the upper left entry "**3**", and a separation is present at the third position. The current indicator value remains 2.

For the entry "**3**" of the current position, the current indicator value 2 is greater than the upper left entry "1", thus the receiver focuses on the upper right entry "**2**", and no separation is present at the fourth position. The current indicator value is decreased by the value of the upper left entry, which is indicated by the entry "1" in a box, so that the current indicator value is set to 1.

For the entry "**2**" of the current position, the current indicator value 2 is greater than the upper left entry "1", thus the receiver focuses on the upper right entry "**1**", and no separation is present at the fifth position. The current indicator value is decreased by the value of the upper left entry, which is indicated by the entry "1" in a box, so that the current indicator value is set to 0.

For the entry "**1**" of the current position, the current indicator value 0 is smaller than the upper left entry "**1**",

thus a separation is present at the sixth and last position.

The assignment of resources according to the invention can e.g. be used for mobile communication systems within the so-called Third Generation Partnership Project Long Term Evolution (3GPP LTE). Here, radio resources can be assigned in a frequency-selective manner that takes into account the expected quality of the radio resources and distributes them among the user data in the best possible way.

To enable the correct reception of the user data which are located on different radio resources, the user terminal need to receive the corresponding announcements of resource assignments prior to or together with the user data. The amount of possibilities for the resource assignments will be limited to a reasonable number to avoid large overhead. The overhead is necessary because all simultaneous transmissions within one Transmit Time Interval (TTI) have to be announced simultaneously. In the following, a highly efficient and scalable method for the announcement of radio resources is proposed that is ideally adapted, but not limited to OFDM-based systems (OFDM = Orthogonal Frequency Division Multiplexing):

In the example, a 5MHz frequency band consists of 25 resource units, i.e. frequency subbands. Radio resources are assigned in a frequency-selective way, i.e. the fourth to the eighth resource units and the eighth to thirteenth resource unit are assumed to be labelled to be "for use", all other resource units are to be labelled "not for use". The following 4 approaches can be used to signal this information.

Approach I:

The used radio resources are indicated by a bitmap, i.e. 25 bits are necessary to indicate the 25 resource units.

Zeros indicate that the corresponding resource unit is not used for the user terminal to which the announcement of resource assignments is sent, while ones indicate that this resource is used and shall thus be received.

Thus, the bitmap "0001111100111000000000000" indicates that resource units 4 to 8 and 11 to 13 are sent to the user terminal.

In total 25 bits are used by this method for resource assignments.

Approach II:

Because completely scattered transmissions like e.g. transmissions using every second resource unit indicated by the bitmap "0101010101010101010101010" are unlikely to be beneficial, the current assumption is that radio resources will be used in one or more resource areas comprising consecutive resource units, just like in the example of approach I.

Thus, another solution is to only signal the number of resource areas and both the start and the end of each used resource area. Applied to the above example, this means that one bit is necessary to indicate the number of resource areas, e.g. to differentiate between one and two resource areas, and 4*5 bits are necessary to signal the start and stop positions of each resource area. In the following representation, the start and end values given in the lower row are encoded using 5 bits as depicted in the upper row, and 1 additional bit in the upper row indicates the number of resource areas as given in the lower row:

| 1 | 00100 | 01000 | 01011 | 01111 |
|---|---|---|---|---|
| areas=2 | start=4 | end=8 | start=11 | end=13 |

In total, 21 bits are used to announce the same information as in approach I.

Approach III:

If resource areas are reasonably small, it is also possible to announce start and length in number of resource units of a resource area instead of start and end. In case the length is limited to 15, 4 bits would be sufficient as shown below. The start and length values given in the lower row are encoded using 5 and 4 bits respectively as depicted in the upper row, and 1 additional bit in the upper row indicates the number of resource areas as given in the lower row:

| 1 | 00100 | 0101 | 01011 | 0011 |
|---|---|---|---|---|
| areas=2 | start=4 | length=5 | start=11 | length=3 |

In total 19 bits would be used to announce the same information as in the above approaches.

Approach IV (corresponding to the invention):

According to the presented new method, separations can be placed both before and after any resource unit to separate the used and unused resource areas. The number of used resource areas still has to be signaled by one bit.

The number of bits that have to be sent for two resource areas is $\mathrm{ld}\left(\begin{pmatrix} 26 \\ 4 \end{pmatrix}\right) =$

$\mathrm{ld}\left(\dfrac{26*25*24*23}{1*2*3*4}\right) = 13.87\ \mathrm{bits,}$ which means that 14 bits will be sufficient to perform the signaling.

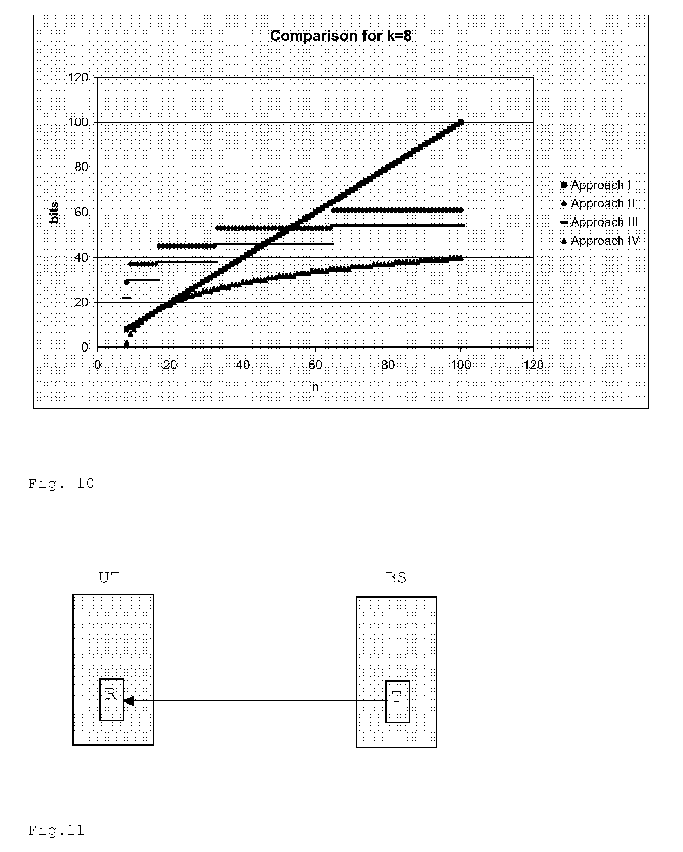

In total only 1+14 bits = 15 bits would be required to transport the same information as in the above approaches.
For the above described approaches, specific parameters were chosen to ease the explanation. To show that the efficiency of the invented algorithm, i.e. approach IV, is generally much better compared to the other methods, i.e. approaches I-III, fig. 10 shows a diagram in which the number of necessary bits for the signaling is depicted over the total number of resource units n for a number of k=8 separations for the approaches I-IV described above.
In the examples described above, signaling of resource assignments is performed by means of indicating positions of separations between resource units. However signaling of resource assignments can also be performed by means of indicating positions before or after resource units or by means of directly indicating positions of resource units. In an embodiment of the invention, a modus value can be used to indicate what kind of position is used.
An exemplary communication network in which the invention can be implemented comprises user terminals and base stations.
Each of said user terminals is connected to one or multiple of said base stations, and the base stations are in turn connected to a core network.
Fig. 11 schematically shows the communication between a user terminal UT and a base station BS.
The user terminals UT comprise the functionality of a user terminal for transmission and reception in a communication network using e.g. frequency division multiplexing transmission, i.e. they can be connected to a network by means of a base station BS.
The base stations BS comprise the functionality of a base station of a communication network e.g. for frequency division multiplexing transmission, i.e. they provide the possibility for user terminals UT to get connected to the communication network.
Furthermore, a base station BS according to the invention comprises at least one transmitter T for signaling of resource assignments of resource units into a number of resource areas by means of indicating k dedicated positions from n positions each identifying at least one of said resource units, whereby said at least one transmitter T comprises at least one processing means adapted to perform

• defining the value for the binomial coefficient $\begin{pmatrix} n \\ k \end{pmatrix}$ as a starting value $\begin{pmatrix} n'' \\ k'' \end{pmatrix}$,

• carrying out for each of the n positions each identifying at least one of said resource units the following evaluation in a recursive procedure using a recursion variable m for covering all positions:

o if there is one of said k dedicated positions on position m of said n positions each identifying at least one of said resource units, the binomial coefficient $\begin{pmatrix} n'-1 \\ k'-1 \end{pmatrix}$ is taken as new starting value $\begin{pmatrix} n' \\ k' \end{pmatrix}$,

o if there is none of said k dedicated positions on position m of said n positions each identifying at least one of said resource units, an indicator value is increased by the binomial coefficient $\begin{pmatrix} n'-1 \\ k'-1 \end{pmatrix}$, and the binomial

coefficient $\begin{pmatrix} n'-1 \\ k' \end{pmatrix}$ is taken as new starting value $\begin{pmatrix} n' \\ k' \end{pmatrix}$,

o and the variable m is changed,

• and signaling of said indicator value indicating the resource assignments.

Additionally, a user terminal UT according to the invention comprises at least one receiver (R) for decoding an indicator value that is indicating resource assignments of resource units into a number of resource areas by means of indicating k dedicated positions from n positions each identifying at least one of said resource units, whereby said at least one receiver (R) comprises at least one processing means adapted to perform

• defining the value for the binomial coefficient $\binom{n}{k}$ as a starting value $\binom{n''}{k''}$,

• and carrying out for each of the n positions each identifying at least one of said resource units the following evaluation in a recursive procedure using a recursion variable m for covering all positions:

o if the indicator value is smaller than the binomial coefficient $\binom{n''-1}{k''-1}$, there is one of said k dedicated positions on position m of said n positions each identifying at least one of said resource units, and the binomial coefficient $\binom{n''-1}{k''-1}$ is taken as new starting value $\binom{n''}{k''}$,

o if the indicator value is greater than or equal to the binomial coefficient $\binom{n''-1}{k''-1}$, there is none of said k dedicated positions on position m of said n positions each identifying at least one of said resource units, the indicator value is decreased by the binomial coefficient $\binom{n''-1}{k''-1}$, and the binomial coefficient $\binom{n''-1}{k''}$ is taken as new starting value $\binom{n''}{k''}$,

o and the variable m is changed.

In fig. 11, the signaling of resource assignments by means of sending an indicator value from the transmitter T of the base station BS to the receiver R of the user terminal UT is indicated by an arrow.

**Claims**

1. A method for signaling of resource assignments of resource units into a number of resource areas by means of indicating k dedicated positions from n positions each identifying at least one of said resource units, **characterized in, that**

• the value for the binomial coefficient $\binom{n}{k}$ is defined as a starting value $\binom{n'}{k'}$,

• for each of the n positions identifying at least one of said resource units, the following evaluation is performed in a recursive procedure using a recursion variable m for covering all positions:

o if there is one of said k dedicated positions on position m of said n positions each identifying at least one

8

of said resource units, the binomial coefficient $\begin{pmatrix} n'-1 \\ k'-1 \end{pmatrix}$ is taken as new starting value $\begin{pmatrix} n' \\ k' \end{pmatrix}$,

o if there is none of said k dedicated positions on position m of said n positions each identifying at least one of said resource units, an indicator value is increased by the binomial coefficient $\begin{pmatrix} n'-1 \\ k'-1 \end{pmatrix}$, and the

binomial coefficient $\begin{pmatrix} n'-1 \\ k' \end{pmatrix}$ is taken as new starting value $\begin{pmatrix} n' \\ k' \end{pmatrix}$,

o and the variable m is changed,

- and after said recursive procedure is performed for each of the n positions each identifying at least one of said resource units, said indicator value is signaled indicating the resource assignments.

2. A method according to claim 1, **characterized in, that** said positions are at least one of positions of, between, before or after said resource units.

3. A method according to claim 2, **characterized in, that** a modus value indicates what kind of position is used.

4. A method according to claim 1, **characterized in, that** values for binomial coefficients are taken from a storage table for Pascal's triangle.

5. A method according to claim 1, **characterized in, that** for decoding of said indicator value,

- the value for the binomial coefficient $\begin{pmatrix} n \\ k \end{pmatrix}$ is defined as a starting value $\begin{pmatrix} n'' \\ k'' \end{pmatrix}$,

- and for each of the n positions each identifying at least one of said resource units, the following evaluation is performed in a recursive procedure using a recursion variable m for covering all positions:

o if the indicator value is smaller than the binomial coefficient $\begin{pmatrix} n''-1 \\ k''-1 \end{pmatrix}$, there is one of said k dedicated positions on position m of said n positions each identifying at least one of said resource units, and the

binomial coefficient $\begin{pmatrix} n''-1 \\ k''-1 \end{pmatrix}$ is taken as new starting value $\begin{pmatrix} n'' \\ k'' \end{pmatrix}$,

o if the indicator value is greater than or equal to the binomial coefficient $\begin{pmatrix} n''-1 \\ k''-1 \end{pmatrix}$, there is none of said k dedicated positions on position m of said n positions each identifying at least one of said resource units, the indicator value is decreased by the binomial coefficient $\begin{pmatrix} n''-1 \\ k''-1 \end{pmatrix}$, and the binomial coefficient

$\begin{pmatrix} n''-1 \\ k'' \end{pmatrix}$ is taken as new starting value $\begin{pmatrix} n'' \\ k'' \end{pmatrix}$,

o and the variable m is changed.

6. A method according to claim 1, **characterized in, that** said signaling of resource assignments is performed between a base station and a user terminal of a communication network.

7. A method according to claim 1, **characterized in, that** said resources are one of time intervals, frequency subbands or modulation or coding schemes.

8. A transmitter (T) for signaling of resource assignments of resource units into a number of resource areas by means of indicating k dedicated positions from n positions each identifying at least one of said resource units, **characterized in, that** said transmitter (T) comprises at least one processing means adapted to perform

• defining the value for the binomial coefficient $\binom{n}{k}$ as a starting value $\binom{n'}{k'}$,

• carrying out for each of the n positions each identifying at least one of said resource units the following evaluation in a recursive procedure using a recursion variable m for covering all positions:

   o if there is one of said k dedicated positions on position m of said n positions each identifying at least one of said resource units, the binomial coefficient $\binom{n'-1}{k'-1}$ is taken as new starting value $\binom{n'}{k'}$,

   o if there is none of said k dedicated positions on position m of said n positions each identifying at least one of said resource units, an indicator value is increased by the binomial coefficient $\binom{n'-1}{k'}$ and the binomial coefficient $\binom{n'}{k'}$, is taken as new starting value $\binom{n'}{k'}$,

   o and the variable m is changed,

• and signaling of said indicator value indicating the resource assignments.

9. A receiver (R) for decoding an indicator value that is indicating resource assignments of resource units into a number of resource areas by means of indicating k dedicated positions from n positions each identifying at least one of said resource units, **characterized in, that** said receiver (R) comprises at least one processing means adapted to perform

• defining the value for the binomial coefficient $\binom{n}{k}$ as a starting value $\binom{n''}{k''}$,

• and carrying out for each of the n positions each identifying at least one of said resource units the following evaluation in a recursive procedure using a recursion variable m for covering all positions:

   o if the indicator value is smaller than the binomial coefficient $\binom{n''-1}{k''-1}$, there is one of said k dedicated positions on position m of said n positions each identifying at least one of said resource units, and the binomial coefficient $\binom{n''-1}{k''-1}$ is taken as new starting value $\binom{n''}{k''}$,

   o if the indicator value is greater than or equal to the binomial coefficient $\binom{n''-1}{k''-1}$, there is none of said k dedicated positions on position m of said n positions each identifying at least one of said resource units, the indicator value is decreased by the binomial coefficient $\binom{n''-1}{k''-1}$, and the binomial coefficient

$\begin{pmatrix} n''-1 \\ k'' \end{pmatrix}$ is taken as new starting value $\begin{pmatrix} n'' \\ k'' \end{pmatrix}$,

o and the variable m is changed.

**10.** A user terminal (UT) of a communication network comprising at least one receiver (R) for decoding an indicator value that is indicating resource assignments of resource units into a number of resource areas by means of indicating k dedicated positions from n positions each identifying at least one of said resource units, **characterized in, that** said at least one receiver (R) comprises at least one processing means adapted to perform

• defining the value for the binomial coefficient $\begin{pmatrix} n \\ k \end{pmatrix}$ as a starting value $\begin{pmatrix} n'' \\ k'' \end{pmatrix}$,

• and carrying out for each of the n positions each identifying at least one of said resource units the following evaluation in a recursive procedure using a recursion variable m for covering all positions:

o if the indicator value is smaller than the binomial coefficient $\begin{pmatrix} n''-1 \\ k''-1 \end{pmatrix}$, there is one of said k dedicated positions on position m of said n positions each identifying at least one of said resource units, and the binomial coefficient $\begin{pmatrix} n''-1 \\ k''-1 \end{pmatrix}$ is taken as new starting value $\begin{pmatrix} n'' \\ k'' \end{pmatrix}$,

o if the indicator value is greater than or equal to the binomial coefficient $\begin{pmatrix} n''-1 \\ k''-1 \end{pmatrix}$, there is none of said k dedicated positions on position m of said n positions each identifying at least one of said resource units, the indicator value is decreased by the binomial coefficient $\begin{pmatrix} n''-1 \\ k''-1 \end{pmatrix}$, and the binomial coefficient $\begin{pmatrix} n''-1 \\ k'' \end{pmatrix}$ is taken as new starting value $\begin{pmatrix} n'' \\ k'' \end{pmatrix}$,

o and the variable m is changed.

**11.** A base station (BS) of a communication network comprising at least one transmitter (T) for signaling of resource assignments of resource units into a number of resource areas by means of indicating k dedicated positions from n positions each identifying at least one of said resource units, **characterized in, that** said at least one transmitter (T) comprises at least one processing means adapted to perform

• defining the value for the binomial coefficient $\begin{pmatrix} n \\ k \end{pmatrix}$ as a starting value $\begin{pmatrix} n'' \\ k'' \end{pmatrix}$,

• carrying out for each of the n positions each identifying at least one of said resource units the following evaluation in a recursive procedure using a recursion variable m for covering all positions:

o if there is one of said k dedicated positions on position m of said n positions each identifying at least one of said resource units, the binomial coefficient $\begin{pmatrix} n'-1 \\ k'-1 \end{pmatrix}$ is taken as new starting value $\begin{pmatrix} n' \\ k' \end{pmatrix}$,

o if there is none of said k dedicated positions on position m of said n positions each identifying at least one of said resource units, an indicator value is increased by the binomial coefficient $\begin{pmatrix} n'-1 \\ k'-1 \end{pmatrix}$, and the

binomial coefficient $\binom{n'-1}{k'}$ is taken as new starting value $\binom{n'}{k'}$,

o and the variable m is changed,

• and signaling of said indicator value indicating the resource assignments.

12. A communication network comprising user terminals (UT) and at least one base station (BS) comprising at least one transmitter (T) for signaling of resource assignments of resource units into a number of resource areas by means of indicating k dedicated positions from n positions each identifying at least one of said resource units **characterized in, that** said at least one transmitter (T) comprises at least one processing means adapted to perform

• defining the value for the binomial coefficient $\binom{n}{k}$ as a starting value $\binom{n''}{k''}$,

• carrying out for each of the n positions each identifying at least one of said resource units the following evaluation in a recursive procedure using a recursion variable m for covering all positions:

o if there is one of said k dedicated positions on position m of said n positions each identifying at least one of said resource units, the binomial coefficient $\binom{n'-1}{k'-1}$ is taken as new starting value $\binom{n'}{k'}$,

o if there is none of said k dedicated positions on position m of said n positions each identifying at least one of said resource units, an indicator value is increased by the binomial coefficient $\binom{n'-1}{k'-1}$, and the

binomial coefficient $\binom{n'-1}{k'}$ is taken as new starting value $\binom{n'}{k'}$,

o and the variable m is changed,

• and signaling of said indicator value indicating the resource assignments.

00000111111000000111111

00000|1111111|000000|1111111

Fig. 1

```
              1
            1   1
          1   2   1
        1   3   3   1
      1   4   6   4   1
    1   5   10   10   5   1
   1   6   15   20   15   6   1
 1   7   21   35   35   21   7   1
 ...................................
```

Fig. 2

| column no. | -1 | 0 | 1 | 2 | 3 | 4 | 5 | 6 | 7 | 8 |
|---|---|---|---|---|---|---|---|---|---|---|
| row no. | | | | | | | | | | |
| 0 | | 0 | 1 | | | | | | | |
| 1 | | 0 | 1 | 1 | | | | | | |
| 2 | | 0 | 1 | 2 | 1 | | | | | |
| 3 | | 0 | 1 | 3 | 3 | 1 | | | | |
| 4 | | 0 | 1 | 4 | 6 | 4 | 1 | | | |
| 5 | | 0 | 1 | 5 | 10 | 10 | 5 | 1 | | |
| 6 | | 0 | 1 | 6 | 15 | 20 | 15 | 6 | 1 | |
| 7 | | 0 | 1 | 7 | 21 | 35 | 35 | 21 | 7 | 1 | |
| 8 | | 0 | 1 | 8 | 28 | 56 | 70 | 56 | 28 | 8 | 1 |

Fig. 3

| | | | |
|---|---|---|---|
| XXXOOO | 00000 | 00 | |
| XXOXOO | 00001 | 01 | |
| XXOOXO | 00010 | 02 | |
| XXOOOX | 00011 | 03 | |
| XOXXOO | 00100 | 04 | a |
| XOXOXO | 00101 | 05 | |
| XOXOOX | 00110 | 06 | |
| XOOXXO | 00111 | 07 | |
| XOOXOX | 01000 | 08 | |
| XOOOXX | 01001 | 09 | |
| OXXXOO | 01010 | 10 | |
| OXXOXO | 01011 | 11 | |
| OXXOOX | 01100 | 12 | b |
| OXOXXO | 01101 | 13 | |
| OXOXOX | 01110 | 14 | |
| OXOOXX | 01111 | 15 | |
| OOXXXO | 10000 | 16 | |
| OOXXOX | 10001 | 17 | c |
| OOXOXX | 10010 | 18 | |
| OOOXXX | 10011 | 19 | d |

Fig. 4

$$
\begin{array}{ccccccccccccc}
 & & & & & & 1 & & & & & & \\
 & & & & & 1 & & 1 & & & & & \\
 & & & & 1 & & 2 & & 1 & & & & \\
 & & & 1 & & 3 & & 3 & & \underline{\mathbf{1}} & & & \\
 & & 1 & & 4 & & 6 & & \underline{\mathbf{4}} & & 1 & & \\
 & 1 & & 5 & & 10 & & \underline{\mathbf{10}} & & 5 & & 1 & \\
1 & & 6 & & 15 & & \underline{\mathbf{20}} & & 15 & & 6 & & 1 \\
\end{array}
$$

$$1 \quad 7 \quad 21 \quad 35 \quad 35 \quad 21 \quad 7 \quad 1$$

. . . . . . . . . . . . . . . . . . . . . . . . . . . . . . . . .

Fig. 5

upper left position
(if separation is present)

upper right position
(if no separation is present)

If a separation is present,
move to the upper left
position

If no separation is present,
move to the upper right;
add the value represented by the upper left
position to the indicator value

current position

Fig. 6

EP 1 937 016 A1

**1**

1

**1**

1

**2**

1

1

**3**

3

1

1

4

**6**

4

1

1

5

10

**10**

5

1

1

6

15

**20**

15

6

1

1

7

21

35

35

21

7

1

| Box |
|---|
| Separation at 6<sup>th</sup> pos.; top of triangle → STOP and SEND indicator_value=12 |
| No separation at 5th pos.; Add 1; indicator_value=12 |
| No separation at 4th pos.; Add 1; indicator_value=11 |
| Separation at 3rd pos.; Add 0; indicator_value=10 |
| Separation at 2nd pos.; Add 0; indicator_value=10 |
| No separation at 1st pos.; Add 10; indicator_value=10 |
| Starting position=20; initial indicator_value=0 |

OXXOOX

Fig. 7

upper left position
(if separation is present)

upper right position
(if no separation is
present)

If
indicator_value < value of the upper left position,
a separation is present; move to the upper left

If
indicator_value >= value of the upper left position,
no separation is present; move to the upper right;
subtract the value represented by the upper left position
from the indicator_value

current position

Fig. 8

18

1

1

1      1

1      2      1

1      3      1

1      4      6      4      1

1      5      10      10      5      1

1      6      15      20      15      6      1

1      7      21      35      35      21      7      1

0<1, i.e. separation at 6th pos. ;
top of triangle → STOP

1>=1, i.e. no separation at 5th pos.;
subtr. 1 → indicator_value=0

2>=1, i.e. no separation at 4th pos.;
subtr. 1 → indicator_value=1

2<3, i.e. separation at 3rd pos.;
indicator_value=2

2<6, i.e. separation at 2nd pos.;
indicator_value=2

12>=10, i.e. no separation at 1st pos.;
subtr. 10 → indicator_value=2

Starting position=20; received
indicator_value=12

OXXOOX

Fig. 9

Fig. 10

Fig.11

**EP 1 937 016 A1**

**European Patent Office**

# EUROPEAN SEARCH REPORT

Application Number

EP 06 30 1266

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | NTT DOCOMO, ET AL.: "RB-level Distributed Transmission Method for Shared Data Channel in E-UTRA Downlink" 3GPP TSG RAN WG1 MEETING #46, [Online] no. R1-062285, 28 August 2006 (2006-08-28), XP002438907 Tallin, Estonia Retrieved from the Internet: URL:www.3g99.org> [retrieved on 2007-06-21] * page 1, line 14 - page 3, line 12 * | 1-12 | INV. H04Q7/38 |
| Y | PIETER J ET AL: "ALGORITHM FOR SOURCE CODING" IEEE TRANSACTIONS ON INFORMATION THEORY, IEEE SERVICE CENTER, PISCATAWAY, NJ, US, vol. IT-18, no. 3, May 1972 (1972-05), pages 395-399, XP000939278 ISSN: 0018-9448 * page 396, left-hand column, line 19 - line 34 * | 1-12 | |
| A | ERICSSON, ET AL.: "E-UTRA Downlink Control Signaling - Overhead Assessment" 3GPP TSG RAN WG1 MEETING #44, [Online] no. R1-060573, 13 February 2006 (2006-02-13), XP002438908 Denver, USA Retrieved from the Internet: URL:www.3gpp.org> [retrieved on 2007-06-21] section 2. Downlink Scheduling Information -/-- | 1-12 | **TECHNICAL FIELDS SEARCHED (IPC)** H03M H04Q |

The present search report has been drawn up for all claims

| Place of search | Date of completion of the search | Examiner |
|---|---|---|
| Munich | 22 June 2007 | Zembery, Peter |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

20

**European Patent Office**

**EUROPEAN SEARCH REPORT**

Application Number

EP 06 30 1266

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| D,A | COVER T M: "ENUMERATIVE SOURCE ENCODING" IEEE TRANSACTIONS ON INFORMATION THEORY, IEEE SERVICE CENTER, PISCATAWAY, NJ, US, vol. IT-19, no. 1, January 1973 (1973-01), pages 73-77, XP001031014 ISSN: 0018-9448 * abstract * ----- | 1-12 | |
| A | US 4 075 622 A (LAWRENCE JOHN C ET AL) 21 February 1978 (1978-02-21) * column 5, line 5 - line 68 * ----- | 1-12 | |

TECHNICAL FIELDS SEARCHED (IPC)

The present search report has been drawn up for all claims

| Place of search | Date of completion of the search | Examiner |
|---|---|---|
| Munich | 22 June 2007 | Zembery, Peter |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 06 30 1266

This annex lists the patent family members relating to the patent documents cited in the above-mentioned European search report.
The members are as contained in the European Patent Office EDP file on
The European Patent Office is in no way liable for these particulars which are merely given for the purpose of information.

22-06-2007

| Patent document cited in search report | Publication date | Patent family member(s) | Publication date |
|---|---|---|---|
| US 4075622 A | 21-02-1978 | NONE | |

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **T.M. COVER.** Enumerative Source Coding. *IEEE Trans. Inform. Theory,* January 1973, vol. IT-19 (1), 73-77